# EUROPEAN PATENT APPLICATION

(11) **EP 1 752 564 A1**
(43) Date of publication of application: **14.02.2007**
(21) Application number: 05765627.4
(22) Date of filing: 18.05.2005
(51) Int. Cl.: C30B 7/00, C30B 29/58, C30B 30/08

(54) **DEVICE AND METHOD FOR COUNTER-DIFFUSION CRYSTAL GROWTH**

(30) Priority: 19.05.2004 ES 200401200
(71) Applicant: CONSEJO SUPERIOR DE INVESTIGACIONES CIENTIFICAS, 28006 Madrid (ES)
(72) Inventor: GARCÍA RUÍZ, Juan Manuel, 18002 Granada (ES)
(74) Representative: Ungria Lopez, Javier
(86) International application number: PCT/ES2005/070068
(87) International publication number: WO 2005/113864

(57) **Abstract**

The invention relates to a device which enables crystallisation (e.g. of biological macromolecules) by means of counter-diffusion. The inventive device consists of a one-dimensional space, for example a capillary tube, comprising three differently-shaped parts. The invention also relates to a block which comprises several of the aforementioned devices and which can be used to perform crystallisation experiments simultaneously under different conditions. The invention further related to a method of growing crystals by means of counter-diffusion in one-dimensional devices either under terrestrial gravity conditions or under reduced gravity conditions, preferably with the use of the block comprising several of said devices in the latter case.

## Description

### OBJECT OF THE INVENTION

The invention relates to a device which enables crystallisation (e.g. of biological macromolecules) by means of counter-diffusion. The inventive device consists of a one-dimensional space, for example a capillary tube, comprising three differently-shaped parts. The invention also relates to a block which comprises several of the aforementioned devices and which can be used to perform crystallisation experiments simultaneously under different conditions. The invention further related to a method of growing crystals by means of counter-diffusion in one-dimensional devices either under terrestrial gravity conditions or under reduced gravity conditions, preferably with the use of the block comprising several of said devices in the latter case.

### STATE OF THE ART

The crystallisation of biological macromolecules under reduced gravity or "microgravity" conditions in space is carried out by different methods which may be divided into two major groups. The first of these groups comprises the techniques in which the crystallisation takes place inside a small, quasi-spherical volume and may therefore be referred to as sphere-shaped. These techniques include the conventional vapor phase techniques, which are the techniques most used up until the year 2000 in space experiments (US-5641681). As of that point in time, the technique of counter-diffusion under far-from-equilibrium conditions which are carried out in longitudinal reactors and therefore pertain to the group we refer to as long techniques (see Patents ES 2164032 and ES 2172363), have progressively taken the place of the former. In these longitudinal techniques, it is aimed to achieve a continuous change in space and time of the supersaturation conditions along the axis of the reactor where the crystals are grown. In the counter-diffusion technique, the solutions which are going to react are placed facing one another in direct contact with or separated from one another by means of a membrane or by a chamber in between serving as a physical buffer, in other words, as a chamber which slows the kinetics of the transport process. This chamber may be filled with a chemical buffer or with any liquid, e.g. water. By definition, counter-diffusion techniques require that convection inside the crystallisation area be prevented. There are two ways of reducing this convection: by performing the experiments under microgravity conditions in space or rather by performing them in gelled media. These two media, microgravity in space and gels both entail the reduction of the convection caused by flotation, the reduction of the concentration of impurities on the crystalline surface and the elimination of the sedimentation of crystals and the secondary nucleation of protein aggregates. In addition thereto, microgravity eliminates the possible chemical interaction of the gel with the reagents including proteins. The counter-diffusion technique has been used in space in reactors of several microliters volume which need to be turned on by the ship's crew, this technique having been proven by means of video-interferometry to work appropriately under reduced gravity conditions (J.M. García-Ruiz, F. Otálora, M.L. Novella, J.A. Gavira, C. Sauter and O. Vidal. A supersaturation wave in protein crystallization. Journal of Crystal Growth 232, 2001, 149-155). For the fast, simple growth of macromolecular crystals in land-based laboratories, the gel acupuncture method was developed, which is based on the properties of gels which are used to fix capillaries containing the ungelled protein solution, as well as due to its being a medium for the transfer of matter from the precipitating agent. The precipitating agent and the protein move in counter-diffusion through the porous gel which fixes the capillaries. The protein solution moves at a lower speed due to the fact that the constant diffusion of the large macromolecules is one or two orders of magnitude lower than the small molecules are which used as a precipitating agent. When they come into contact, the protein concentration progressively increases up to the point of reaching the degree of supersaturation which gives rise to the formation of crystals (J.M. Garcia-Ruiz et al., "Teaching protein crystallization by the gel acupuncture method"; Journal of Chem Education 75, 1998, 442-446; F. Otálora and J.M. Garcia-Ruiz, "Computer model of the diffusion/reaction interplay in the Gel Acupuncture Method", Journal of Crystal Growth 169, 1996, 361-367; J.M. Garcia-Ruiz, Counterdiffusion methods for protein crystallisation. Methods in Enzimology 368 (2003) 130-154). The counter-diffusion method developed by J.M. García-Ruiz et al., is based on commencing the crystallisation experiments under far-from-equilibrium conditions seeking multiple nucleation events under conditions progressively nearing equilibrium. By using this method, the system undergoes precipitation phenomenon which take place at different supersaturation values. The first nucleation events take place under very far-from-equilibrium conditions, giving rise to amorphous precipitation. The following events will take place under conditions nearer to equilibrium with polycrystalline precipitation. Thus, as the process progresses, the system slowly nears equilibrium, giving rise to fewer crystals, but of higher quality. Each one of these precipitations takes place at different locations in the capillary. These experiments has been conducted both by the gel acupuncture method as well as by the.triple-layer method (H.K. Henisch, Crystal growth in gels and Liesegang rings, Cambridge University Press, 1988) in X-ray capillaries (Joseph D. Ng, José A. Gavira and Juan M. Garcia-Ruiz, Protein crystallization by capillary counterdiffusion for applied crystallographic structure determination, Journal of Structural Biology 142, 2003, 218-231). To facilitate the experimenting, a device known as the Granada Crystallisation Box (GCB) was developed, affording the possibility of easily implementing the gel acupuncture method (J.M. Garcia-Ruiz, L.A. González, J.A. Gavira and F. Otálora. GranadaCrystallisation Box: a new device for protein crystallisation by counter-diffusion techniques. Acta Crystallographica D58, 2002, 1638-1642). This device (GCB) can function properly in space without needing to be handled by the ship's crew. For this purpose, some special containers, known as the "Granada Crystallisation Facility" were built, fully meeting the safety requirements for manned orbital vehicle experimentation, which are capable of holding up to 23 GCB's measuring one liter in volume and one kilogram in weight.

### EXPLANATION OF THE INVENTION

The prime object of this invention is a device for counter-diffusion crystal growth consisting of a one-dimensional space, preferably a capillary tube, comprising three differently-shaped parts.
a) a capillary cylinder of (a diameter) a length ranging from 50 microns to 2 millimeters and over 10 mm in length such that the counter-diffusion technique can be appropriately carried out as defined J.M. García-Ruiz, Counterdiffusion methods for protein crystallisation. Methods in Enzimology 368 (2003) 130-154).
b) The capillary vessel, which may be cylindrical, prism-shaped, conical or of any other shape, but the volume of which must be greater than five times the volume of the capillary cylinder.
c) Optionally, between the capillary cylinder and the capillary vessel, there may be a neck or interface (capillary neck) which is cylindrical, prism-shaped, conical or of any other shape and which is smaller than the volume of the capillary vessel.

The capillary tube may be made either of glass or of a polymer material which is transparent or non-transparent to X-rays. Optionally, the capillary vessel is equipped with a cover providing for the press-fit hermetic seal of the vessel by pressing on the outer edge of said vessel.

The inventive device can be used individually or integrated into a block comprising several of the aforementioned devices and which can be used to perform crystallisation experiments simultaneously under different conditions.

The aforementioned block for simultaneously carrying out counter-diffusion crystal growth processes in one-dimensional -preferably capillary- spaces, comprises of the following elements:
a) outer box comprised of a prism-shaped, cylindrical or spherical housing which is closed with two covers equipped with watertight seals, the outermost of the aforementioned covers fitting onto the housing by means of a set of pressure screws.
b) at least one internal device which is placed inside the outer box and is of a shape compatible with that corresponding shape of the outer box
c) one-dimensional -preferably capillary- devices, arranged inside internal device or devices b).

A first configuration of the internal device consists of a solid block consisting of regularly-distributed holes which are of the necessary shape for inserting the one-dimensional devices and which is closed with a cover equipped with a watertight seal.

A second configuration of the internal device is comprised of a set of 2 to 10 modules, which consist of regularly-distributed holes of the shape necessary for inserting the one-dimensional devices.

A third configuration of the internal device is comprised of a set of 2 to 10 modules, which consist of regularly-distributed spaces of the shape necessary for inserting up to 20, preferably up to 11 boxes of the type known as the Granada Crystallisation Box (GCB), each of which contains 1 to 50 one-dimensional - preferably capillary- devices.

A fourth configuration of the internal device would be comprised of a set of 2 to 10 modules, one to nine of which consist of regularly-distributed holes of the shape necessary for inserting the one-dimensional devices and between 1 and 9 comprise regularly-distributed holes of the necessary shape for inserting up to 20, preferably up to 11 GCB-type boxes, each containing 1 to 50 one-dimensional - preferably capillary - devices.

The outer box and the internal device are made of any material which does not interact with the chemical agents which are used in the crystal growth processes, preferably in polymer, ceramic, metal or glass material. Optionally, a free volume is left between the outer box and the internal device which is filled with bags of phase-change material which is used for keeping the temperature stable inside the box. Likewise, as an option, a module containing a Peltier thermoelectric element and electronic systems for maintaining the temperature can be attached to the outer box.

This invention further relates to a method of growing crystals by means of counter-diffusion in the aforementioned one-dimensional - preferably capillary - devices, which consists of the following stages:
a) pouring the solution with the product to be crystallized into the capillaries up to the level of the lower part of the neck of the capillary or of the capillary tube.
b) sealing the bottom of the capillaries with wax, high vacuum grease, sealing wax or any other product which will ensure the watertightness of the seal.
c) optionally, filling the neck of the capillaries with a chemically-inert gel.
d) placing on the inert gel filling the neck of the capillaries or directly onto the capillary vessel the precipitating agent solution which will completely or partially fill the capillary vessel.
e) hermetically sealing the capillary vessel
f) starting the diffusive mass transport of the precipitating agent toward the solution which contains the compound to be crystallised.
g) crystallization inside the capillaries such that, as the process progresses, higher-quality crystals are produced due to approaching equilibrium conditions.
The compound to be crystallised is preferably a biological macromolecule.

The solution which contains the compound to be crystallized is comprised of an organic or inorganic solvent, preferably water, water with a pH buffer or water with surface-active product.

The inert gel is a chemically-inert agent such as agarose and derivative materials, polyacrylamide or silica gel, or any porous medium which will serve to prevent convection.

The precipitating agent is generally any compound which reduces the solubility of the compound to be crystallized, such as an inorganic salt, for example sodium chloride or ammonium sulfate, or rather a polymer or alcohol e.g. polyethylene glycol.

The process can be performed under terrestrial gravity conditions or rather under reduced gravity conditions. In the latter of these two cases, the method is performed preferably in the block described hereinabove which groups together several of the one-dimensional devices.

### BRIEF DESCRIPTION OF THE FIGURES

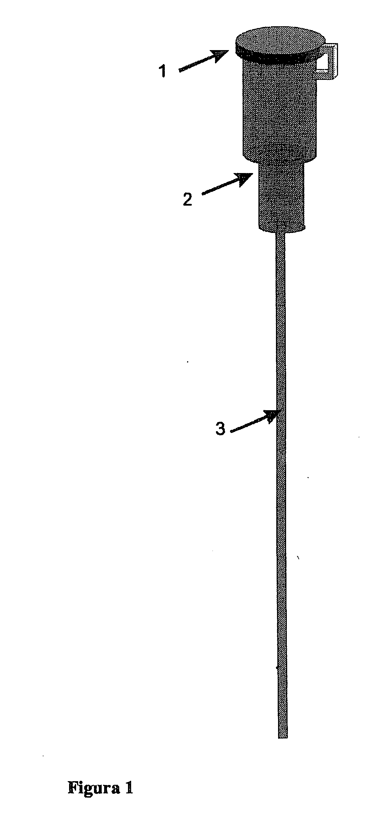

**Figure 1:** Counter-diffusion device with cylindrical vessel and cylindrical neck.

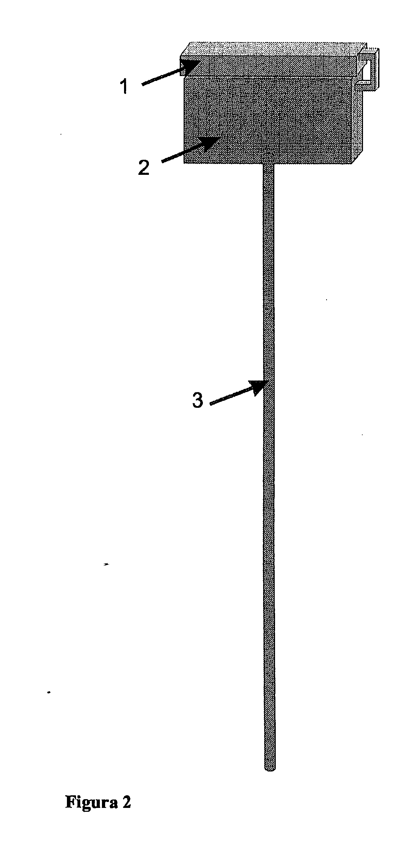

**Figure 2:** Counter-diffusion device with parallelelogram-based vessel without neck.
**Figure 3.** Cross-section of the block for simultaneously performing counter-diffusion crystal growth processes.
**Figure 4:** Cross-section of the internal device showing the arrangement of the holes for inserting the one-dimensional - preferably capillary - devices.
**Figure 5:** Perspective and side views of one of the modules which may comprise the internal device, which comprises regularly-distributed holes of the necessary shape for inserting the one-dimensional devices.
**Figure 6:** View of a module consisting of regularly-distributed holes of the necessary shape for inserting up to 20, preferably 11 boxes, of the type known as the Granada Crystallisation Box (GCB).
**Figure 7:** View of a configuration of the internal device in which four modules with GCB boxes and three modules with holes for the one-dimensional devices are included.
**Figure 8:** View of the block for simultaneously performing crystal growth processes including as the internal device as configuration like that shown in Figure 7 hereinabove and with a Peltier thermoelectric element attached to the outer box.

### DETAILED DESCRIPTION OF THE INVENTION

The invention is characterized in that it comprises three differently-shaped parts.

The first of these parts is a capillary cylinder per se measuring longer than 10 millimeters in length and having a diameter ranging from 50 microns to 2 millimeters. The second, which is optional, is the capillary neck, which is U-shaped and measures 0.1 to 2 millimeters in length. Due to its shape, the diameter of the neck varies continuously or discontinuously between the diameter of the capillary cylinder and the diameter of the vessel. The third is the capillary vessel, which can be 10-30 millimeters in length and of a width up to 30 times the diameter of the capillary cylinder. The inventive capillary is characterized in that it is shaped such that the vessel will have a volume greater than five times the volume of the capillary cylinder. This shape is fundamental for the counter-diffusion crystallization because it ensures that - once equilibrium has been reached - the concentration of precipitating agent inside the capillary cylinder will be similar to the initial concentration inside the vessel. Thus, it can be ensured that the supersaturation wave will run the full length of the capillary. The capillaries currently available have a vessel volume-capillary cylinder volume ratio which is too small for the counter-diffusion process to take place throughout the full length of the capillary.

The capillaries of this invention, whether made of glass or plastic (transparent or non-transparent to X-rays) may be of a capillary diameter ranging from 50 microns to 2 millimeters in diameter.

The method for growing crystals by means of counter-diffusion in the devices of this invention consists of the following stages:
a) The solution with the product to be crystallized is placed inside the glass devices up to the level of the bottom of the capillary neck. The solvent used for the solution containing the product to be crystallized is water, water with a pH buffer or water with a surface-active product. The compound to be crystallized is generally a biological macromolecule.
b) The bottom of the capillary is sealed using wax, high-vacuum grease or sealing-wax or any other products which ensures the watertightness of the seal.
c) The capillary neck is filled with a gel. The gel is a chemically-inert agent such as agarose and derivative materials, polyacrylamide or silica gel or any other porous medium which serves to prevent convection.
d) The precipitating agent is placed on the gel and the capillary is closed with a septum. The precipitating agent is generally any compound which reduces the solubility of the product to be crystallized (e.g. an inorganic salt, such as sodium chloride or ammonium sulfate or rather a polymer or an alcohol (e.g. polyethylene glycol). A change in the pH of the medium can also be used as a precipitating agent.
e) Hermetic sealing of the capillary vessel.

As of this point in time, the diffusive mass transport of the precipitating agent toward the solution containing the compound to be crystallized commences, the crystallization taking place inside the capillaries such that as the process progresses, higher-quality crystals are produced as a result of nearing equilibrium conditions.

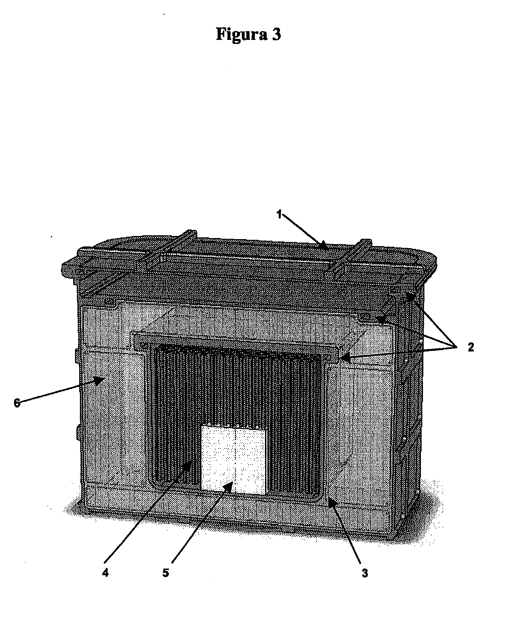

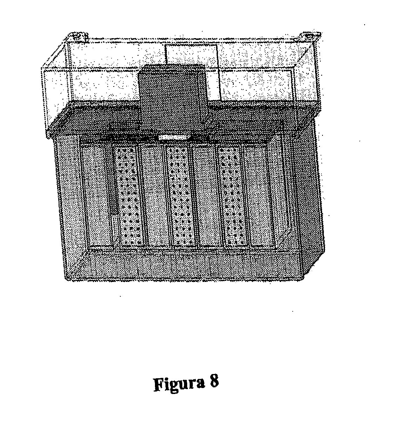

The invention also relates to a block (see Figures 3 and 8) which comprises several of the aforementioned devices for counter-diffusion crystal growth and which can be used to perform crystallization experiments simultaneously under different conditions, especially in space, under reduced gravity conditions. This block optimizes the number of experiments per unit of weight and volume and facilitates and reduces the length of time necessary for implementing the experiments prior to the integration thereof into the spaceship. The inventive block is comprised of an outer box (1) consisting of a box body and a cover which are adjustable by means of watertight seals (2) ("O-rings") and a set of pressure screws which ensure the hermetic seal thereof.

The body of the box contains an internal device inside which may be of different configurations. In an initial configuration (see Figure 3), the internal device consists of a second box (internal box) (3) which is a solid block in which a number of regularly-distributed holes (4) have been made which are of the necessary shape for inserting the one-dimensional devices. The devices, which are generally capillary) are inserted into these holes following the completion of the aforementioned experiment preparation protocol. It may also optionally include a hole (5) for attaching a sensor for recording temperatures.

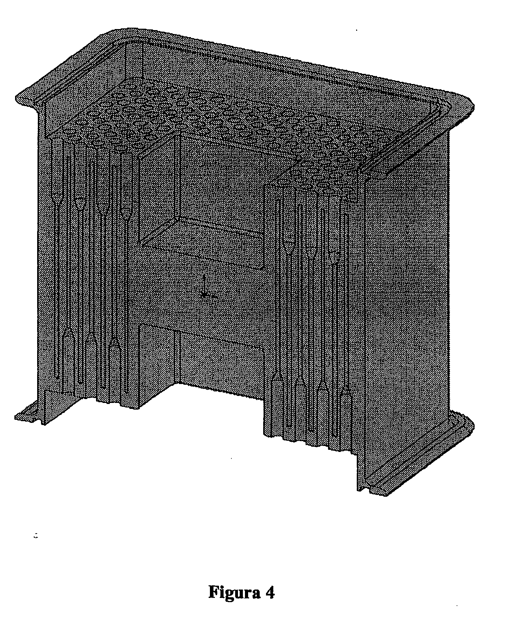

The internal box (see Figure 4) can be made of polymer, ceramic, metal or glass material and, in general, of any material which will not interact with the chemical agents which are used in the crystallization experiments. The free volume between the internal box and the outer box (see Figure 3) can be divided into compartments (6) which are filled with bags of phase-change material which is used for keeping the temperature stable inside the box.

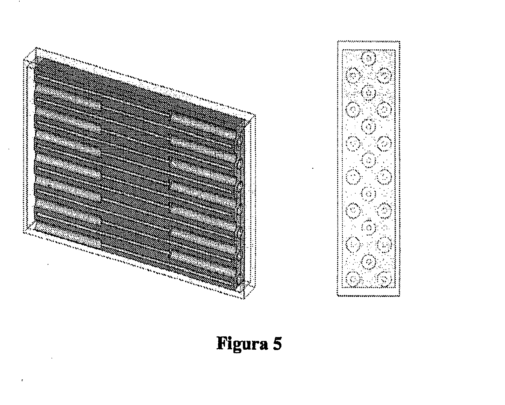

Figures 5, 6 and 7 show other possible configurations of the internal devices of the block for simultaneously performing crystallisation processes.

Thus, Figure 5 shows one of the modules which, numbering 2 to 10 in number, comprise said internal device. In this figure, these modules include regularly-distributed holes for inserting the one-dimensional devices.

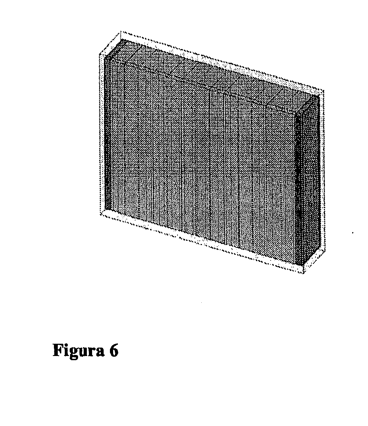

Figure 6 shows a module which contains spaces for housing boxes of those known as GCB's (see Patents ES 2164032 and ES 2172363).

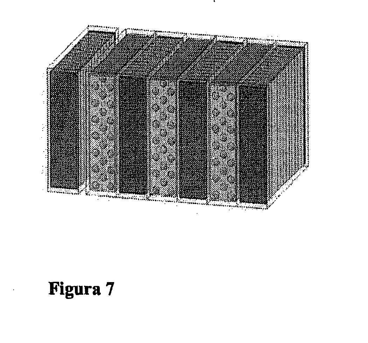

Figure 7 shows a configuration of the internal device in which four modules with GCB boxes and three modules with holes for the one-dimensional devices are included.

Figure 8 shows a block comprising several of the aforementioned devices for counter-diffusion crystal growth and which can be used to perform crystallisation experiments simultaneously under different conditions. In this figure, the internal device is of the same configuration as in Figure 7, and a module which includes a Peltier thermoelectric element and electronic systems for keeping the temperature stable having been attached to the outer box.

In addition to providing the advantages of the Granada Crystallisation Facility to which reference is made in the State of the Art section, this block also provides the following advantages with regard thereto:
a) it is better in keeping with the advantages of the counter-diffusion technique
b) it increases the number of capillaries per unit of volume
c) it betters the mechanical response to vibration
d) it facilitates fast, safe implementation in reduced time spans

### EMBODIMENT OF THE INVENTION

### Example of counter-diffusion device with cylindrical vessel and cylindrical neck

1) A cylindrical glass capillary (1) volume of 0.7 millimeters in diameter by 50 millimeters in length. The volume of this cylinder to be filled with protein solution is 19.23 microliters.
2) The capillary vessel (3) is made of polystyrene and is comprised of two contiguous cylinders. The bottom cylinder or capillary neck has inner dimensions of 1.5 mm in diameter by 20 millimeters in length for a total volume of 35.33 microliters. The upper cylinder or capillary vessel per se has internal dimensions of 2 millimeters in diameter by 30 millimeters in height, for a total volume of 376.8 microliters. The vessel of the capillary has a cover closing it hermetically on the outside, such that the closure does not exert pressure on the inside of the device. The capillary vessel cover is attached to the capillary vessel by means of a polystyrene elastic band.
3) The capillary neck (2) has an opening at the center of its bottom through which the capillary is inserted flush with the bottom part, the capillary being sealed to the body of the capillary vessel without obstructing the capillary.

### Process of use of the counter-diffusion device with a cylindrical vessel and cylindrical neck under terrestrial gravity conditions.

1) The appropriate amount of 0.12% low-gel-point agarose is mixed with a sodium acetate solution buffered to pH 4.5. This mixture is heated to boiling and allowed to cool down to five degrees above the gelling temperature.
2) Next, 25 microliters of the agarose solution is mixed with 7.5 milligrams of lysozyme for preparing a 30% lysozyme solution.
3) When the solution is still above the gelling point, the capillary volume is filled by capillarity by submerging the bottom end thereof into the solution with agarose. The protein solution flows upward to the top of the capillary level with the bottom of the capillary vessel.
4) The end through which the capillary has been filled is closed using wax and is allowed to cool to room temperature for five minutes so that the agarose gains consistency.
5) 200 microliters of a 3-molar sodium chloride solution buffered with sodium acetate to pH 4.5 is then poured into the capillary vessel neck.
6) The capillary vessel cover is closed.

### Example of counter-diffusion device with a neckless parallelogram-based vessel.

1) A cylindrical glass capillary (1) volume of 0.1 millimeters in diameter by 40 millimeters in length. The volume of this cylinder to be filled with protein solution is 0.314 microliters.
2) The capillary vessel (2) is made of polystyrene and has inner dimensions of 5 mm in diameter by 2.5 millimeters in depth by 20 millimeters in height, for a total volume of 250 microliters. The vessel of the capillary has a cover (3) closing it hermetically on the outside, such that the closure does not exert pressure on the inside of the device. The capillary vessel cover is attached to the capillary vessel by means of a polystyrene elastic band. The capillary vessel has an opening at the center of its bottom through which the capillary is inserted flush with the bottom part, the capillary being sealed to the body of the capillary vessel without obstructing the capillary.

### Process for using the counter-diffusion device with a neckless parallelogram-based prism counter-diffusion device.

1) The capillary volume is filled by capillarity by submerging a bottom end thereof into the 30 mg/ml concentration lysozyme solution of an acetate-buffered pH 4.5. The protein solution flows upward to the top of the capillary level with the bottom of the capillary vessel.
2) The end through which the capillary has been filled is closed using wax.
3) Ten microliters of a 3-molar sodium chloride solution buffered with sodium acetate to pH 4.5 is poured into the vessel of the capillary. The capillary vessel cover is closed.

### Process for using the counter-diffusion device with cylindrical vessel and cylindrical neck under reduced gravity conditions in space.

1) A 30% lysozyme solution is prepared with 7.5 milligrams of lysozyme and 25 microliters of a solution with sodium acetate at pH 4.5.
2) The capillary volume is filled by capillarity by submerging the bottom end thereof into the lysozyme solution buffered to pH 4.5 with acetate. The protein solution flows upward to the top of the capillary level with the bottom of the capillary vessel.
3) The end through which the capillary has been filled is closed using wax and is allowed to cool to room temperature for 5 minutes so that the agarose will take on consistency.
4) One milliliter of an 0.12% low-gelling-point agarose solution is prepared, is heated to boiling and allowed to cool down to five degrees above the gelling temperature.
5) When the agarose solution is still fluid and above the gelling point, the neck of the capillary is filled with 35 microliters of agarose,solution using a pipette and is allowed to cool to room temperature for a few minutes.
6) Two hundred microliters of a 3-molar sodium chloride solution buffered with sodium acetate to pH 4.5 are poured into the neck-vessel of the capillary.
7) The capillary vessel cover is closed.
8) The one-dimensional device (capillary) is inserted into a block for simultaneously performing counter-diffusion crystal growth processes, for which purpose it is inserted into a hole made in a module which, in turn, is integrated with 7 similar modules into the inside of an outer prism-shaped box.

## Claims

1. Device for counter-diffusion crystal growth consisting of a one-dimensional space, preferably a capillary tube, **characterized in that** it comprises three differently-shaped parts:
a) a capillary cylinder of a diameter ranging from 50 microns to 2 millimeters and a length of over 10 mm.
b) a capillary vessel which may be cylindrical, prism-shaped, conical or of any other shape, but the volume of which must be greater than five times the volume of the capillary cylinder.
c) optionally, between the capillary cylinder and the vessel of the capillary there may be a neck or interface (capillary neck) which is cylindrical, prism-shaped, conical or of any other shape and the volume of which is smaller than the volume of the capillary vessel.

2. Device for counter-diffusion crystal growth according to Claim 1, **characterized in that** the capillary tube is made of glass or of a polymeric material which is transparent or non-transparent to X-rays.

3. Device for counter-diffusion crystal growth according to Claims land 2, **characterized in that** the vessel of the capillary is equipped with a cover allowing the hermetic sealing of the vessel by pressure on the outer edge of said vessel.

4. Use of a device for counter-diffusion crystal growth according to Claims 1-3 for its integration in a block comprising several different devices, allowing performance of simultaneous crystallisation experiments under different conditions.

5. Block for performing simultaneous counter-diffusion crystal growth experiments in one-dimensional preferably capillary - spaces consisting of the following elements:
d) outer box comprised by a prism-shaped, cylindrical or spherical housing which closes using two covers equipped with watertight seals, the outermost cover being fitted to the housing by means of a set of pressure screws.
e) at least one internal device which is placed inside the outer box and which is of a shape compatible with the corresponding shape of the outer box.
f) One-dimensional - preferably capillary - devices arranged inside internal device or devices b).

6. Block for simultaneously performing counter-diffusion crystal growth processes according to Claim 5, **characterized in that** the internal device is a solid block which comprises regularly-distributed holes of the necessary shape for inserting the one-dimensional devices and which is closed with a cover equipped with a watertight seal.

7. Block for simultaneously performing counter-diffusion crystal growth processes according to Claim 5, **characterized in that** the internal device comprises a set of 2 to 10 modules, which comprise regularly-distributed holes of the necessary shape for inserting the one-dimensional devices.

8. Block for simultaneously performing counter-diffusion crystal growth processes according to Claim 5, **characterized in that** the internal device comprises a set of 2 to 10 modules, which comprise regularly-distributed holes of the necessary shape for inserting up to 20, preferably up to 11, boxes, each one of which contains 1 to 50 one-dimensional - preferably capillary - devices.

9. Block for simultaneously performing counter-diffusion crystal growth processes according to Claim 5, **characterized in that** the internal device comprises a set of 2 to 10 modules, one to nine of which comprise regularly-distributed holes of the necessary shape for inserting the one-dimensional devices and one to nine comprising regularly-distributed spaces of the necessary shape for inserting up to 20, preferably up to 11, boxes, each one of which contains 1 to 50 one-dimensional - preferably capillary - devices.

10. Block for simultaneously performing counter-diffusion crystal growth processes in space according to Claim 5-9, **characterized in that** the outer box and the internal device are made of any material which does not interact with the chemical agents which are used in the crystal growth processes, preferably polymeric, ceramic, metal or glass material.

11. Block for simultaneously performing counter-diffusion crystal growth processes in space according to Claim 5-9, **characterized in that** a free volume is optionally left between the outer box and the internal device which is filled with bags of phase-change material which is used to keep the temperature stable inside the box.

12. Block for simultaneously performing counter-diffusion crystal growth processes in space according to Claim 5-9, **characterized in that** a module containing a Peltier thermoelectric element and electronic systems for maintaining the temperature is optionally attached to the outer box.

13. Process for growing crystals by means of counter-diffusion in one-dimensional -preferably capillary-devices according to Claims 1-3 hereinabove, **characterized in that** it comprises the following stages:
a) putting the solution with the product to be crystallized into the capillaries up to the level of the upper part of the neck or of the vessel of the capillary.
b) sealing the bottom of the capillaries using wax, high-vacuum grease, sealing-wax or any other product which will ensure the watertightness of the seal.
c) optional filling of the neck of the capillaries with a chemically-inert gel.
d) placing a solution of precipitating agent which will fully or partially fill the vessel of the capillaries on the inert gel which fills the neck of the capillaries or directly onto the vessel of the capillary.
e) hermetic sealing of the vessel of the capillaries.
f) commencing the diffusive mass transport of the precipitating agent toward the solution containing the compound to be crystallized.
g) Crystallisation inside the capillaries such that as the process progresses, higher-quality crystals are obtained due to nearing conditions of equilibrium.

14. Process for growing crystals by means of counter-diffusion according to Claim 13, **characterized in that** the compound to be crystallized is a biological macromolecule.

15. Process for growing crystals by means of counter-diffusion according to Claims 13 and 14, **characterized in that** the solution containing the compound to be crystallized consists of an organic or inorganic solvent.

16. Process for growing crystals by means of counter-diffusion according to Claim 15, **characterized in that** the solvent used for the solution containing the compound to be crystallized is water, water with a pH buffer or water with a surface-active product.

17. Process for growing crystals by means of counter-diffusion according to Claims 16-17, **characterized in that** the inert gel is a chemically-inert agent such as agarose and derivative materials, polyacrylamide or silica gel, or any porous medium which will serve to prevent convection.

18. Process for growing crystals by means of counter-diffusion according to Claims 13-17, **characterized in that** the precipitating agent is generally any compound which will reduce the solubility of the compound to be crystallized.

19. Process for growing crystals by means of counter-diffusion according to Claim 18, **characterized in that** the precipitating agent is an inorganic salt (e.g. sodium chloride or ammonium sulfate).

20. Process for growing crystals by means of counter-diffusion according to Claim 18, **characterized in that** the precipitating agent is a polymer or an alcohol, for example polyethylene glycol.

21. Process for growing crystals by means of counter-diffusion according to Claims 13-20, **characterized in that** the entire process is carried out under terrestrial gravity conditions.

22. Process for growing crystals by means of counter-diffusion according to Claims 13-20, **characterized in that** the contact between the precipitating agent and the solution with the product to be crystallized and the resulting crystallization inside the capillaries is carried out under reduced gravity conditions.

23. Process for growing crystals by means of counter-diffusion according to Claim 22, **characterized in that** the process is preferably carried out in the one-dimensional devices integrated into a block according to Claims 5-12.
